# EUROPEAN PATENT APPLICATION

(11) **EP 4 847 539 A1**
(43) Date of publication of application: **02.12.2026**
(21) Application number: 26181753.0
(22) Date of filing: 28.05.2026
(51) Int. Cl.: C08F 8/28, A46B 3/04, C08F 8/32, C08J 3/24, C08K 5/07, C08K 5/17

(54) **BRUSHES, SYSTEMS, AND METHODS FOR POST-CMP CLEANING OF A SURFACE**

(30) Priority: 30.05.2025 US 202563815379 P; 22.05.2026 US 202619685592
(71) Applicant: Illinois Tool Works Inc., Glenview IL 60025 (US)
(72) Inventor: KUMAR, Ashavani, Glenview, 60025 (US); HUGHES, Corey Alan, Glenview, 60025 (US); LUO, Yuyan, Glenview, 60025 (US); NELSON, Erik, Glenview, 60025 (US)
(74) Representative: HGF

(57) **Abstract**

Disclosed novel composition for a molded and cured brush include, by weight: 5-20% of polyvinal acetal; 1-10% of an aldehyde, a diamine, or a solution containing an aldehyde and a diamine; 0.01-2% of a surfactant; 1-40% of acid; and 60-90% of water.

## Description

### RELATED APPLICATIONS

The present application claims the benefit of U.S. Provisional Patent Application Serial No. 63/815,379, filed May 30, 2025, entitled "BRUSHES, SYSTEMS, AND METHODS FOR POST-CMP CLEANING OF ASURFACE." The entirety of U.S. Provisional Patent Application Serial No. 63/815,379 is expressly incorporated herein by reference.

### FIELD OF THE DISCLOSURE

The present disclosure relates to substrate-cleaning brushes, and more particularly, to brushes, systems, and methods for post-chemical-mechanical planarization (CMP) cleaning of a surface.

### BACKGROUND

In the semiconductor manufacturing industry and other industries, brushes are used to remove contaminants from surfaces, such as from semiconductor wafers. Depending on the specific application, cleaning of a substrate or surface may also involve delivery of one or more substances (e.g., chemicals, ultra-pure water (UPW), deionized water (DIW), etc.) to the substrate or surface.

Limitations and disadvantages of conventional approaches to conditioning brushes will become apparent to one of skill in the art, through comparison of such approaches with some aspects of the present method and system set forth in the remainder of this disclosure with reference to the drawings.

### SUMMARY

Brushes, systems, and methods for post-CMP cleaning of a surface are disclosed, substantially as illustrated by and described in connection with at least one of the figures, as set forth more completely in the claims.

### BRIEF DESCRIPTION OF THE DRAWINGS

These and/or other aspects will become apparent and more readily appreciated from the following description of the exemplary embodiments, taken in conjunction with the accompanying drawings.
FIGS. 1A and 1B illustrate an example system including multiple cylindrical brushes configured to perform post-CMP cleaning of a substrate, in accordance with aspects of this disclosure.
FIG. 2 is a flowchart representative of an example method to form the brushes to include raised portions and recessed portions, in accordance with aspects of this disclosure.
FIG. 3 is a flowchart representative of an example method to form the foam and mold the molded and cured brush.

The figures are not necessarily to scale. Where appropriate, similar or identical reference numbers are used to refer to similar or identical components.

### DETAILED DESCRIPTION

Various applications and processes may benefit from physical cleaning of a surface. For example, in semiconductor manufacturing, a semiconductor wafer may be cleaned to remove potentially destructive contaminants during one or more stages of fabricating electronic circuits on the wafer. The cleaning can be provided by, for example, a brush that comes in contact with the surface to be cleaned. Brushes may take different forms depending on the application, such as roller brushes and pencil brushes.

To efficiently clean a substrate, disclosed example brushes come into contact with a substrate to be cleaned in the presence of a cleaning chemical. Brushes may come in different forms (e.g., pencil brush, roller brush). Conventional brushes had a starch-based formulation that could leave residue on a surface cleaned using the conventional brush. Starch is only partially soluble in water and may swell, but not fully dissolve. As a result, conventional starch-containing brushes are prone to leaving behind microparticles or films on the surfaces of objects cleaned using the brushes. Also, starch molecules can have adhesive properties and/or contain ionic and organic contaminants. Disclosed brushes mitigate (e.g., reduce, eliminate) residue and scratching of semiconductor wafers during cleaning and/or provide improved fluid exchange between the brush surface and the substrate being cleaned.

As used herein, chemicals or process chemicals may refer to any substance that may be applied via disclosed brushes, including water such as DIW and/or UPW.

According to aspects of this disclosure, example novel compositions for a molded and cured brush include, by weight: 5-20% of polyvinal acetal; 1-10% of an aldehyde, a diamine, or a solution containing an aldehyde and a diamine; 0.01-2% of a surfactant; 1-40% of acid; and 60-90% of water.

In some examples, the molded and cured brush includes, by weight: 8-14% of polyvinal acetal; 2-5% of an aldehyde, a diamine, or a solution containing an aldehyde and a diamine; 0.2-1% of a surfactant; 8-18% of acid; and 70-82.5% of water. In some such examples, the molded and cured brush includes, by weight: 10-12% of polyvinal acetal; 3-4% of an aldehyde; 0.4-0.7% of a surfactant; 11.5-13% of acid; and 71.5-74% of water.

In some examples, the aldehyde is formaldehyde. In some examples, the surfactant is a non-ionic surfactant. In some examples, the non-ionic surfactant is Triton^{™} X-100 (TX-100). In some examples, the acid has a pH of 2 or less. In some examples, the acid is a solution of 70% sulfuric acid.

In some examples, the formulation is free of ionic contaminants greater than 200 parts per billion. In some examples, the molded formulation has: compressive stress between 60-120 gm/cm2; pore size between 40-200 um; porosity between 70-95%; apparent density between 0.05-0.1 gm/cc; and water absorbance between 1200-1800%.

According to aspects of this disclosure, example methods of forming a molded and cured brush involve: providing a solution of polyvinal acetal, TX-100, and formaldehyde in water; adding the solution to acid and air in a mixer; mixing the mixture to create a foam; putting the mixture in a mold; setting the mixture at a pre-determined temperature; waiting a pre-determined period of time for the mixture to begin to cure; and quenching the mixture in ammonia.

In some such examples, the pre-determined temperature is between 18 degrees Celsius to 27 degrees Celsius and the pre-determined period of time is at least 2 hours. In some such examples, the pre-determined temperature is at least 120 degrees Fahrenheit and the pre-determined period of time is at least 1 hour.

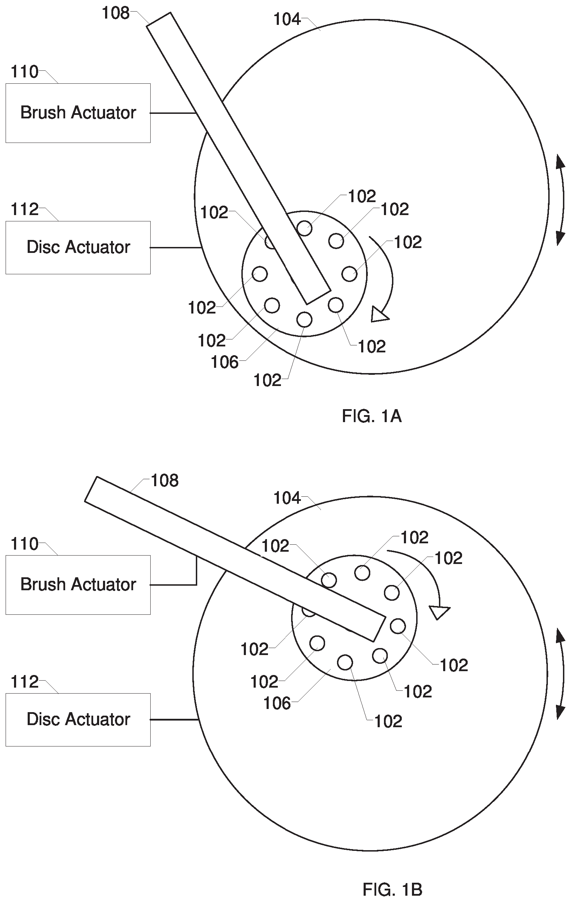

FIGS. 1A and 1B illustrate an example system 100 including multiple cylindrical brushes 102 configured to perform post-CMP cleaning of a substrate 104. FIGS. 1A and 1B show plan views of the brushes 102 and the substrate 104 in different radial and/or angular positions over the surface of the substrate 104 during an example cleaning process.

Brushes may come in different forms (e.g., pencil brush, roller brush). An example pencil brush body is cylindrical and has a circular end surface. However, in other examples the brush body is elliptical, quadrilateral, and/or may have any other end surface shape, with a corresponding end surface shape. The brush body further includes a mounting portion, which couples the brush to a brush holder (e.g., the brush holder 106 of FIG. 1). The mounting portion may extend axially from the brush body 202 and have a smaller or larger dimension . The brush may have recessed portions (linear channels) which are parallel to the end surface of the brush body and extend from edge-to-edge of the brush body. In an example, the recessed portions are curved channels, such as S-shaped channels, concentric channels, and/or otherwise non-linear channels, which are parallel to the end surface of the brush 200. In some other examples, the recessed portions are at least partially transverse (e.g., not parallel) to the end surface to encourage flows of chemical over the surface of the substrate 104. In another example, the brush body is cylindrical and has a circular end surface that includes raised portions and recessed portions. The example raised portions are formed as islands, which are separated from each other in two dimensions by the recessed portions. The raised and recessed portions can be any suitable shape (such as square, circular, elliptical, and/or rectangular, and/or irregular shape, and/or combination of shapes. As such, the recessed portions may be curved, such as S-shaped or concentric.

An example roller brush is a cylindrical shape, and has a substantially even contact surface, which is rotated to clean the surface of the substrate. As used herein, "substantially even" and "substantially flat" refer to a lack of nodules or other protrusions larger than the microtexturing disclosed herein. In an example, a roller brush may be molded with nodules which extend from the surface of the roller brush. The nodules may be regularly spaced over the entirety of the surface of the roller brush, may be un-evenly spaced, and may be formed (i.e., molded) in any suitable shapes, sizes, and/or spacings.

The example brushes 102 are supported, positioned, and rotated via a brush holder 106, which is held and/or moved by a support arm 108. The support arm 108 may also deliver chemical(s) to the surfaces of the brushes 102 and/or directly to the substrate through an annulus of the brush holder 106. For example, chemicals delivered to the surfaces of the brushes 102 may disperse through the bodies of the brushes 102 to the substrate 104. In some examples, the chemicals are delivered from one or more reservoirs, such as via the support arm 108. The reservoirs may be local or proximate to the system 100 and/or may be facility-based supplies of pressurized chemicals in fluid communication with the support arm 108. The chemicals may be controlled using control circuitry and/or one or more valves controlled to set dispensation rates for the chemicals from the reservoirs. Any type of solenoid or other electronically controlled valve may be used, taking into account the desired flow rates, power consumption, and/or response times.

The example substrate 104 may rotate in either direction, or remain stationary, while the support arm 108 moves the brushes 102 over the surface of, and in contact with, the substrate 104 via the brush holder 106. The support arm 108 may further control rotation of the brushes 102 via a spindle coupling the support arm 108 to the brush holder 106. The radial positions of the brushes 102 on the substrate 104 are controlled by moving the support arm 108 with respect to the substrate 104, while the angular positions of the brushes 102 with respect to the surface of the substrate 104 is controlled by rotating the brush holder 106 and/or the substrate 104. However, in other examples, the support arm 108 may be capable of positioning the brushes 102 at any angular and/or radial positions on the substrate 104. The support arm 108 may further control the distance between the brushes 102 and the substrate 104, and/or the pressure applied to the substrate 104 by the brushes 102.

The example system 100 may include one or more actuators, such as one or more brush actuators 110 to move the support arm 108, rotate the brush holder 106 about an axis of the brush holder 106, and/or rotate the brushes 102 about respective axes of the brushes 102. The actuators may include a disc actuator 112 to actuate a platen, stage, conveyor, and/or other support surface that can hold, rotate, and/or convey the substrate 104. In some examples, the disc actuator 112 may actuate the substrate 104 to rotate (e.g., via a platen) in a same or different rotational direction as the rotation of the brushes 102 and/or the brush holder 106 during the cleaning process. In other examples, the disc actuator 112 may convey the substrate 104 in a linear direction, with or without rotation of the substrate 302.

The brush holder 106 may be an annular plate configured to hold the brushes 102. The brush holder 106 may include an annulus for delivery of one or more chemicals. The brush holder 106 may be attached or bonded to the brushes 102, and provides mechanical support and coupling between the brushes 102 and the support arm 108. The brushes 102 are placed into contact with the substrate 104 to clean and/or polish the substrate 104.

While the example system 100 includes several brushes 102 held by the brush holder 106, other numbers and/or arrangements of the brushes 102 may be used, including fewer brushes (e.g., one brush 102, two brushes 102, etc.) or more brushes 102. The brushes 102 may be arranged at a same radial distance from the axis of the brush holder 106, at multiple radial distances from the axis of the brush holder 106, and/or at different positions over the surface of the brush holder 106.

Each of example brushes 102 is a porous polymeric foam, which may be molded, machined, constructed using additive manufacturing techniques, and/or otherwise constructed in a cylindrical shape. For example, the brushes 102 may be formed by casting the porous polymeric foam directly on a mandrel. In other examples, the porous polymeric foam may be formed as a brush body and then assembled and/or mounted onto a mandrel. In some other examples, the brushes 102 are a porous polymer brush and manufactured as a sponge-only brush. Example polymeric foams that may be used to implement the brushes 102 include, but are not limited to, polyvinyl acetal foams, polyurethane foams, polyolefin foams, porous fluoropolymers, silicone foams, polyester foams, nylon foams, and/or polyacrylic foams.

Because the example brushes 102 are porous, one or more chemicals may be dispersed through the brushes 102 toward the substrate 104, and eventually reaches the interfaces between the brushes 102 and the substrate 104. In some examples, the brushes 102 and/or the brush holder 106 are configured to provide substantially even dispersion of chemicals through the brushes 102, to provide different concentrations of the chemicals at different locations within the brushes 102 or different locations on the surface of the brushes, or to focus dispensing of the chemicals at one or more locations on the surface of the brushes 102.

As described in more detail below, after molding and curing of each brush 102, the brush 102 is conditioned to form raised portions separated by recessed portions on an end surface of the brush 102 that contacts the substrate 104.

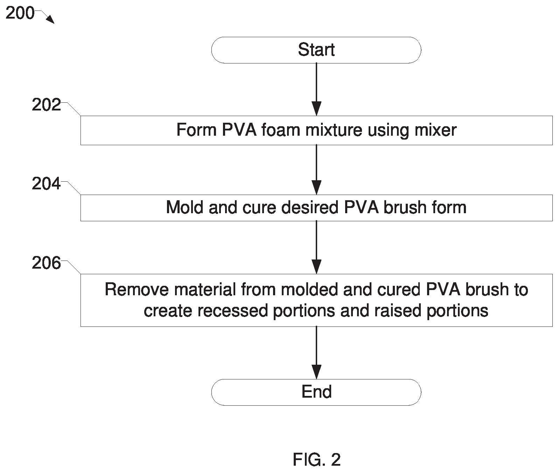

FIG. 2 is a flowchart representative of an example method 200 to form the brushes (e.g., the brushes 102 of FIGS. 1A-1B) to include raised portions and recessed portions.

At block 202, a PVA foam mixture is created using a PVA solution and mixing in gas using a mixing device. The mixing may be provided with air or other gas to form a foam with a PVA solution.

At block 204, the PVA foam mixture is molded into the desired PVA brush form. For example, a cylindrical mold may be used to mold a cylindrical form. The molding may further involve heating and/or curing of the molded foam.

At block 206, the molded and cured foam has material removed to create recessed portions (e.g., the recessed portions) and raised portions (e.g., the raised portions). For example, portions of the brush body may be cut, milled, ablated, or otherwise removed to form the recessed portions separating raised portions. The material removal may involve forming channels parallel to the end surface, in which the channels may be parallel to each other and/or transverse to other channels.

The molding and the curing may result in an internal portion of the brush having a first, higher permeability, and an outer layer of the brush having a second, lower permeability (less than the first permeability). Removing material from the end surface involves removing at least a portion of the outer layer of the brush having the second, lower permeability, such that the raised portions have a higher permeability than if the outer layer remained on the raised portions.

In one embodiment, the composition for the molded and cured brush or brushes comprises five components: polyvinal acetal; an aldehyde, a diamine, or a solution containing an aldehyde and a diamine; a surfactant; an acid; and water.

In certain aspects, polyvinyl acetal (PVA) is present in an amount ranging from about 5 weight percent to about 20 weight percent, more preferably from about 8 weight percent to about 14 weight percent, and most preferably 10 weight percent to about 12 weight percent.

In certain aspects, an aldehyde, a diamine, or a solution containing an aldehyde and a diamine is present in an amount ranging from about 1 weight percent to about 10 weight percent, more preferably from about 2 weight percent to about 5 weight percent, and most preferably 3 weight percent to about 4 weight percent.

In certain aspects, a surfactant is present in an amount ranging from about 0.01 weight percent to about 2 weight percent, more preferably from about 0.2 weight percent to about 1 weight percent, and most preferably 0.4 weight percent to about 0.7 weight percent.

In certain aspects, an acid is present in an amount ranging from about 1 weight percent to about 40 weight percent, more preferably from about 8 weight percent to about 18 weight percent, and most preferably 11.5 weight percent to about 13 weight percent.

In certain aspects, water is present in an amount ranging from about 60 weight percent to about 90 weight percent, more preferably from about 70 weight percent to about 82.5weight percent, and most preferably 71.5 weight percent to about 74 weight percent.

The sum of the components is 100 weight percent unless otherwise specified. In an embodiment, the formulation may contain 0.15 kg PVA; 0.04 kg HCHO; 0.01 kg Triton^{™} X-100 (TX-100) (linear formula: *t*-Oct-C₆H₄-(OCH₂CH₂)ₓOH, x= 9-10) ; 0.17 kg of an acid; and 1.00 kg water.

In an embodiment, the molded and cured brush may have a compressive stress between 60-120 gm/cm². In another embodiment, the molded and cured brush may have a pore size between 40-200 um. In another embodiment, the molded and cured brush may have a porosity between 70-95%. In another embodiment the molded and cured brush may have an apparent density between 0.05-0.1gm/cc. In yet another embodiment, the molded and cured brush may have water absorbance between 1200-1800%. In an embodiment the molded and cured brush may meet one or more or all of the ranges provided in this paragraph.

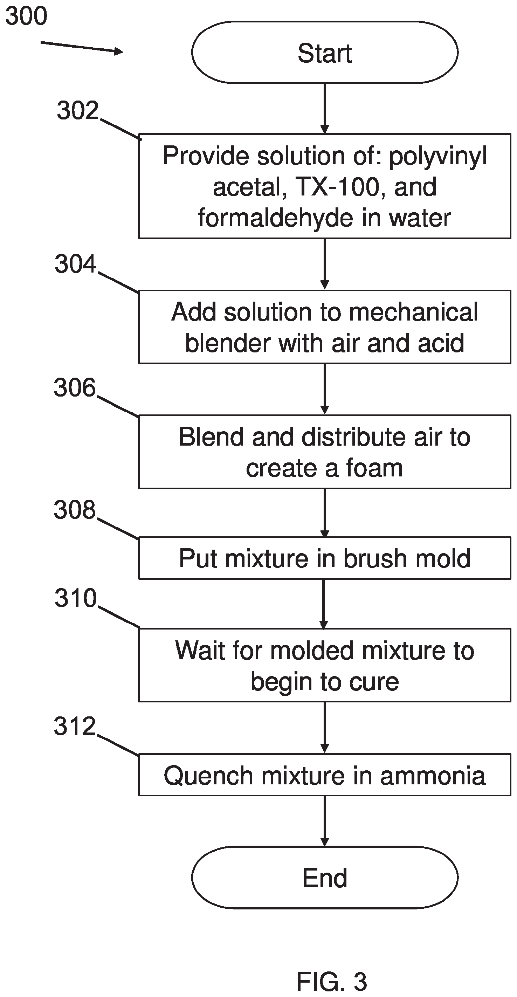

FIG. 3 is a flowchart representative of an example method 300 to form the molded and cured brushes (e.g., the brushes 102 of FIGS. 1A-1B) to include raised portions and recessed portions.

At block 302, a solution of polyvinyl acetal, a surfactant (here TX-100), and formaldehyde in water is provided. In an example, the solution could be mixed immediately prior to usage. In another example, the solution may be pre-mixed and stored, or procured as a complete or partial mixture.

At block 304, the solution is added to a mechanical blender with gas and acid. In an example, the gas may be air or another gas. In an example, the gas may be required to meet certain specifications of cleanliness for use in a cleanroom to prevent the introduction of impurities to the brush manufacturing process.

At block 306, the mixture is blended to distribute the gas and form a foam.

At block 308, the mixture is put in a mold and molded into the desired brush form. For example, a cylindrical mold may be used to mold the desired brush shape (e.g., roller brush or pencil brush). The molding may further involve heating and/or curing of the molded foam.

At block 310, the mixture is left to cure in the mold. In an example, the mixture may be left to cure under room temperature conditions, which may be between 18 degrees Celsius to 27 degrees Celsius (about 64 degrees Fahrenheit to about 81 degrees Fahrenheit) for at least 2 hours. In another example, the mixture may be left to cure under warmer conditions to shorten the cure time. For example, the mixture may be left to cure in an environment that is at least 120 degrees Fahrenheit for at least 1 hour.

At block 312, as the mixture begins to cure, it is quenched in ammonia as part of a process called nitriding. The ammonia dissociates into nitrogen and hydrogen and the nitrogen diffuses into the surface of the material to create a hard nitride layer. In an example, the brush can be removed from the mold or quenching volume, packed, further conditioned, and/or used in wafer cleaning as described above.

As utilized herein, "and/or" means any one or more of the items in the list joined by "and/or." As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g." and "for example" set off lists of one or more non-limiting examples, instances, or illustrations. As utilized herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.

## Claims

1. A novel composition for a molded and cured brush comprising, by weight:
5-20% of polyvinal acetal;
1-10% of an aldehyde, a diamine, or a solution containing an aldehyde and a diamine;
0.01-2% of a surfactant;
1-40% of acid; and
60-90% of water.

2. The molded and cured brush of claim 1, wherein the molded and cured brush comprises, by weight:
8-14% of polyvinal acetal;
2-5% of an aldehyde, a diamine, or a solution containing an aldehyde and a diamine;
0.2-1% of a surfactant;
8-18% of acid; and
70-82.5% of water.

3. The molded and cured brush of claim 2, wherein the molded and cured brush comprises, by weight:
10-12% of polyvinal acetal;
3-4% of an aldehyde;
0.4-0.7% of a surfactant;
11.5-13% of acid; and
71.5-74% of water.

4. The molded and cured brush of claim 1, wherein the aldehyde is formaldehyde.

5. The molded and cured brush of claim 1, wherein the surfactant is a non-ionic surfactant.

6. The molded and cured brush of claim 5, wherein the non-ionic surfactant is Triton^{™} X-100 (TX-100).

7. The molded and cured brush of claim 1, wherein the acid has a pH of 2 or less.

8. The molded and cured brush of claim 7, wherein the acid is a solution of 70% sulfuric acid.

9. The molded and cured brush of claim 1, wherein the formulation is free of ionic contaminants greater than 200 parts per billion.

10. The molded and cured brush and cured composition of claim 9, wherein the molded formulation has:
compressive stress between 60-120 gm/cm²;
pore size between 40-200 um;
porosity between 70-95%;
apparent density between 0.05-0.1 gm/cc; and
water absorbance between 1200-1800%.

11. A method of forming a molded and cured brush comprising the steps of:
(a) providing a solution of polyvinal acetal, TX-100, and formaldehyde in water;
(b) adding the solution to acid and air in a mixer;
(c) mixing the mixture to create a foam;
(d) putting the mixture in a mold;
(e) setting the mixture at a pre-determined temperature;
(f) waiting a pre-determined period of time for the mixture to begin to cure; and
(g) quenching the mixture in ammonia.

12. The method of claim 11, wherein the pre-determined temperature is between 18 degrees Celsius to 27 degrees Celsius and the pre-determined period of time is at least 2 hours.

13. The method of claim 11, wherein the pre-determined temperature is at least 120 degrees Fahrenheit and the pre-determined period of time is at least 1 hour.
